Europäisches Patentamt

European Patent Office

Office européen des brevets

(11) Publication number: **0 133 724**
**A2**

## (12) EUROPEAN PATENT APPLICATION

(21) Application number: **84201113.2**

(22) Date of filing: **30.07.84**

(51) Int. Cl.⁴: **H 03 F 1/32**
**H 03 F 3/19**

(30) Priority: **01.08.83 NL 8302720**

(43) Date of publication of application:
**06.03.85 Bulletin 85/10**

(84) Designated Contracting States:
**DE FR GB IT**

(71) Applicant: **N.V. Philips' Gloeilampenfabrieken**
**Groenewoudseweg 1**
**NL-5621 BA Eindhoven(NL)**

(72) Inventor: **Tuch, Bruce**
**c/o INT. OCTROOIBUREAU B.V. Prof. Holstlaan 6**
**NL-5656 AA Eindhoven(NL)**

(74) Representative: **Schoonheijm, Harry Barend et al,**
**INTERNATIONAAL OCTROOIBUREAU B.V.**
**Prof.Holstlaan 6**
**NL-5656 AA Eindhoven(NL)**

(54) **High-frequency amplifier with distortion compensation.**

(57) HF-amplifier device comprising a first transistor which is controlled at its base by a signal source and whose collector is connected to a load, also comprising a second transistor for compensating for the distortion occurring in the first transistor. According to the invention, this distortion is measured by comparing the collector output voltage of the first transistor with the collector voltage of a so-called third transistor, which is highly linearized by means of negative emitter feedback and which evidences a similar voltage gain as the first transistor and whose base is coupled to the base of the first transistor. Said distortion is thereafter compensated for in the forward direction by using the collector difference voltage of the first and third transistor as a control voltage for a second transistor which is connected to the load as an emitter follower. This results at the same time in a low output impedance of the HF-amplifier device.

FIG.1

High-frequency amplifier with distortion compensation.

The invention relates to a HF-amplifier device comprising a first transistor which is controlled at its base by a signal source and whose collector constitutes the output of the HF-amplifier device and is connected to a load, also comprising a second transistor and a third transistor with negative emitter feedback whose base is coupled to the base of the first transistor, the second transistor being coupled as an emitter follower to the collector of the third transistor and coupled through its emitter to the collector of the first transistor and through its collector to a supply voltage.

Such an HF-amplifier device is disclosed in the article "An integrated IF-amplifier" by W.J. Mc Calla, published in "IEEE Journal of Solid State Circuits", Vol. SC-8, no. 6, December 1973, pages 440-447.

The output impedance of the prior art HF-amplifier device is determined by the emitter output impedance of the second transistor and may consequently be sufficiently low to short-circuit for example signal reflections in the load at the output of the HF-amplifier device or to reduce the influence of variations in the load impedance on the output voltage.

The gain of the known HF-amplifier device is mainly determined by the first transistor and to a lesser extent also by the second transistor. If a high gain is desired, the distortion occurring in the second transistor will have a relatively great effect on the overall distortion as the distortion occurring in the first transistor is partly short-circuited to ground <u>via</u> the second transistor, without passing through the load.

The invention has for its object to provide an HF-amplifier device of the type set forth in the opening paragraph, which distorts to a lesser extent than said prior art HF-amplifier device.

According to the invention, an HF-amplifier of this type is characterized in that the voltage gain of the first transistor is substantially equal to the gain of the third transistor.

When the measure according to the invention is used, a reliable reference of the wanted output voltage is obtained at the collector of the third transistor which is highly linearized by the negative emitter feedback. Variations between this reference and the output voltage produced by the first transistor are compensated for by means of the second transistor. As these variations are only caused by the distortion occurring in the first transistor and as the base-emitter voltage of the second transistor is only determined by these variations, the variation of this base-emitter voltage and consequently also the distortion occurring in the second transistor is much lesser than in said prior art HF-amplifier device, whereas the distortion of the first transistor is completely compensated.

A preferred embodiment of an HF-amplifier device according to the invention is balanced and characterized by fourth, fifth and sixth transistors which are balanced relative to the respective first, second and third transistors, the load being connected between the collectors of the first and fourth transistors.

When this measure is applied the load current is free from direct currents and only the HF-output signal current of the HF-amplifier devices flows through it.

Such a construction is furthermore particularly suitable for use as a preamplifier for an acoustic filter.

The invention will now be further described by way of example with reference to the Figure in the accompanying drawings. Herein:

Figure 1 shows an HF-amplifier device according to the invention.

Figure 2 shows a balanced construction of the HF-amplifier device of Figure 1 comprising an acoustic filter as a load.

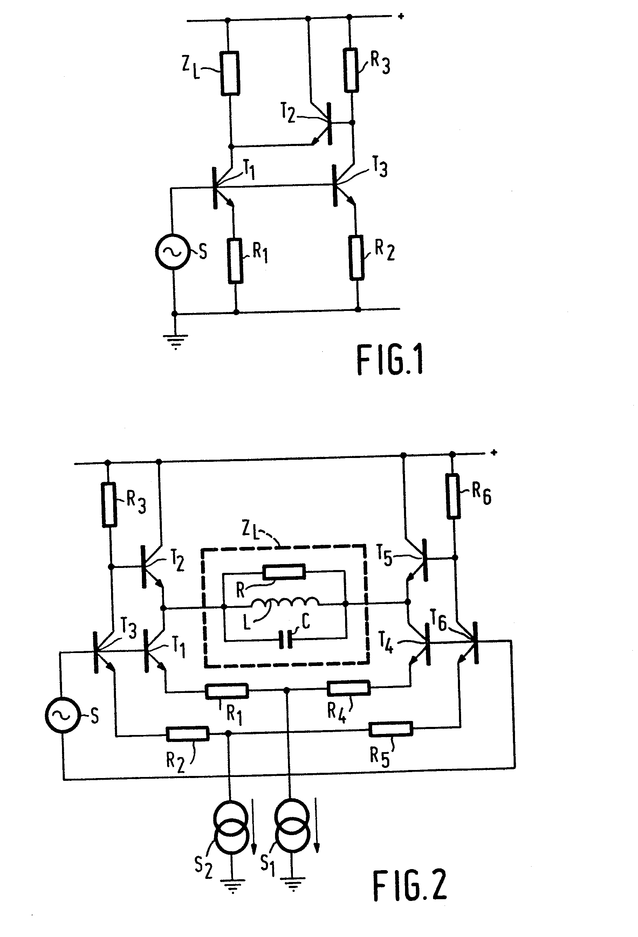

Figure 1 shows an HF-amplifier device according to the invention, comprising a first transistor $T_1$, a so-called third transistor $T_3$ the base thereof being coupled with that of the first transistor $T_1$, and a second transistor $T_2$ which is connected as an emitter follower between the collectors of these two transistors $T_1$ and $T_3$. The bases of the first and third transistors $T_1$ and $T_3$ are connected in common to an input signal source S, their collectors are connected to a supply voltage via a load $Z_L$ and a collector resistor $R_3$ respectively and the emitters are connected to ground via the respective emitter resistors $R_1$ and $R_2$. The emitter of the second transistor $T_2$ is coupled to the collector of $T_1$, the base to the collector of $T_3$ and the collector to a supply voltage.

With the aid of the emitter resistor $R_1$ the transadmittance of

the first transistor $T_1$ is set such that starting from a given load impedance $Z_L$ and a given amplitude of the base input signal the desired output signal amplitude is obtained, or at least approximated at the collector of $T_1$. To that end the emitter resistor $R_1$ may be comparatively small and may be replaced by a current source, not shown, which is short-circuited for high frequency by means of a parallel capacitance. This may cause the signal variation across the non-linear voltage-current characteristic of the base-emitter diode of the first transistor $T_1$ to be comparatively large, which may result in a considerable distortion, in the collector output current of $T_1$.

The distortion component of this collector output current is compensated by the emitter current of the emitter-follower $T_2$, such that the output voltage of the HF-amplifier device, that is to say the voltage across the load $Z_L$ as the result of the total output current applied thereto, follows the collector voltage of the third transistor $T_3$. By linearizing the third transistor $T_3$, it is accomplished that the last-mentioned collector voltage and consequently also the output voltage of the HF-amplifier device varies without distortion versus the base input voltage. To that end, the emitter resistor $R_2$ is chosen such, in a manner known per se, that the voltage variation across the base-emitter diode of this third transistor $T_3$ is at least smaller than the voltage variation of the first transistor $T_1$ and does not cause a noticeable distortion of the collector current. Consequently, the emitter resistor $R_2$ is generally many times larger than the emitter resistor $R_1$.

Starting from a collector current of $T_3$ thus obtained, which varies linearly versus the base input voltage, the amplitude of the collector voltage, and consequently, also the amplitude of the output voltage of the HF-amplifier device can be adjusted to a desired value by means of the collector resistor $R_3$.

If the voltage gain of the first and third transistors $T_1$ and $T_3$ correspond to each other then the said emitter current of $T_2$ predominantly corresponds to the distortion component in the collector output current of the first transistor $T_1$, as a result of which this distortion component is short-circuited to ground via the second transistor $T_2$ without flowing through the load $Z_L$.

If the voltage gains of the first and third transistors $T_1$ and $T_3$ deviate somewhat from each other, for example because of a change in the load impedance $Z_L$, then the second transistor $T_2$ produces an emitter

0133724

04.07.1984

current which not only contains the said distortion component but also a signal component. This signal component produces across the load $Z_L$ a voltage which compensates for the voltage difference between on the one hand the collector voltage of $T_3$ which functions as a reference and on the other hand the voltage across the load $Z_L$ as a result of the collector output current of $T_1$.

HF-signal voltage reflections from the load $Z_L$ towards the HF-amplifier device are shunted to ground _via_ the second transistor $T_2$, so that with, for example, acoustic filters when used as load $Z_L$, so-called triple transient reflections are avoided.

Figure 2 shows a practical balanced construction of the HF-amplifier device of Figure 1 in which corresponding components are given the same reference numerals.

The first transistor $T_1$ forms together with a fourth transistor $T_4$ a first balanced differential amplifier having mutually equal series-arranged emitter resistors $R_1$ and $R_4$ and a setting current source $S_1$ which is connected to ground and to the common junction of $R_1$ and $R_4$. The second transistor $T_2$ forms together with a fifth transistor $T_5$ a second balanced differential amplifier which is arranged in cascode between the first balanced differential amplifier and the supply voltage. The third transistor $T_3$ forms together with a sixth transistor $T_6$ a third balanced differential amplifier which is arranged in parallel with the first balanced differential amplifier with mutually equal series arranged emitter resistors $R_2$ and $R_5$, the common junction thereof being connected to a grounded setting current source $S_2$ and with mutually equal collector resistors $R_3$ and $R_6$ which are arranged between the respective collectors of the transistors $T_3$ and $T_6$ and the supply voltage. The balanced base inputs of the first and third differential amplifiers are jointly connected to the input signal source S which is now of a balanced construction. The base inputs of the second differential amplifier are connected to the collector outputs of the third differential amplifier and its emitter outputs are connected on the one hand to the collectors of the first and fourth transistors $T_1$ and $T_4$ of the first differential amplifier, and on the other hand to the load $Z_L$ which in the given application is formed by an acoustic filter, which is illustrated by a parallel RLC-network RLC.

The functions of the said first, second and third differential amplifiers correspond to the respective functions of the first, second and third transistors of the HF-amplifier device shown in Figure 1.

However, in contrast with the embodiment shown in Figure 1, in which the load $Z_L$ also conveys a direct current which produces a d.c. voltage across the load $Z_L$, corresponding to the collector-emitter voltage of the emitter follower $T_2$, such a direct current through the load $Z_L$ is avoided in the balanced construction shown in Figure 1.

In a practical embodiment comprising an acoustic TV-IF filter as a load $Z_L$, wherein R = 2 K$\Omega$, L = 1.9 $\mu$H and C = 10 pF, the HF-amplifier device functioned as a TV-IF preamplifier and the setting currents sources $S_1$ and $S_2$ had the respective values 1.2 mA and 6.2 mA and the resistors $R_1$ and $R_6$ had the respective values 45$\Omega$, 400$\Omega$, 8 k$\Omega$, 45$\Omega$, 400$\Omega$ and 8 k$\Omega$.

It will be obvious that the invention is not limited to the constructions described in the foregoing and that several alternatives are conceivable within the scope defined by the Claims. It is alternatively possible to connect instead of an acoustic filter a signal processing circuit of a different type as a load to the output of the HF-amplifier device, or, for example, a cable for signal distribution in a community antenna system.

CLAIMS

1.      An HF-amplifier device comprising a first transistor which is controlled at its base by a signal source and whose collector constitutes the output of the HF-amplifier device and is connected to a load, also comprising a second transistor and a third transistor with negative emitter feedback whose base is coupled to the base of the first transistor, the second transistor being coupled as an emitter follower to the collector of the third transistor and coupled through its emitter to the collector of the first transistor and through its collector to a supply voltage, characterized in that the voltage gain of the first transistor is substantially equal to the voltage gain of the third transistor.

2.      An HF-amplifier device as claimed in Claim 1, characterized by fourth, fifth and sixth transistors which are balanced relative to the respective first, second and third transistors, the load being connected between the collectors of the first and fourth transistor.

3.      An amplifier device as claimed in Claim 2, characterized in that the load is formed by an acoustic filter.

FIG.1

FIG.2